# EUROPÄISCHE PATENTSCHRIFT

(11) **EP 3 067 913 B1**
(45) Veröffentlichungstag und Bekanntmachung des Hinweises auf die Patenterteilung: **09.10.2019**
(21) Anmeldenummer: 16159419.7
(22) Anmeldetag: 09.03.2016
(51) Int. Cl.: H01J 37/32, H01J 37/34

(54) **VORRICHTUNG ZUM BEEINFLUSSEN EINER AUSBREITUNG EINES BEI EINEM VAKUUMLICHTBOGENPROZESS GEBILDETEN PLASMAS**
DEVICE FOR INFLUENCING A PROPAGATION OF A PLASMA FORMED DURING A VACUUM ARC PROCESS
DISPOSITIF DESTINE A INFLUENCER UNE PROPAGATION D'UN PLASMA FORME SELON UN PROCEDE D'ARC ELECTRIQUE SOUS VIDE

(30) Priorität: 13.03.2015 DE 102015204592
(43) Veröffentlichungstag der Anmeldung: 14.09.2016
(73) Patentinhaber: Fraunhofer-Gesellschaft zur Förderung der angewandten Forschung e.V., 80686 München (DE)
(72) Erfinder: Englberger, Gregor, 01309 Dresden (DE); Dr. Meyer, Carl-Friedrich, 01328 Dresden (DE)
(74) Vertreter: Pfenning, Meinig & Partner mbB

(56) Entgegenhaltungen:
- EP-A1- 1 727 406
- EP-A1- 2 164 309
- EP-A2- 1 189 258
- DE-C1- 19 850 218

## Beschreibung

Die vorliegende Erfindung betrifft eine Vorrichtung zum Beeinflussen einer Ausbreitung eines bei einem Vakuumlichtbogenprozess gebildeten Plasmas.

Eine Verwendung von Vakuumlichtbogenprozessen, auch unter Einsatz von Lasern, hat sich in vergangenen Jahren für eine industrielle Abscheidung wasserstofffreier amorpher Kohlenstoffschichten etabliert. Hervorzuheben ist hierbei die Laser-Arc-Technologie. Ausschlaggebend für eine industrielle Durchsetzung sind dabei vor allem hohe Abscheideraten über eine Beschichtungshöhe von 500 mm.

Durch eine elektrische Beschaltung, die vergleichbar ist mit einer Beschaltung von Anode, Kathode und Vakuumkammer wie in der Druckschrift DE 198 50 218 C1 beschrieben, kann eine bessere Fokussierung des Plasmas erreicht werden. Mit dieser besseren Fokussierung lassen sich Durchsatz und somit die Abscheiderate erhöhen, da Durchsatzverluste an Flansch- und Kammerwänden minimiert werden. Nachteilig am Einsatz der Filterbeschaltung ist jedoch, dass eine gewünschte Schichtdickenhomogenität von +/- 12,5 Prozent über die Beschichtungshöhe nicht mehr gewährleistet ist.

Ein ähnlicher Prozess ist aus der Druckschrift EP 1 189 258 A2 bekannt. Hierbei wird eine Vorrichtung zum Beeinflussen der Ausbreitung eines bei einem Vakuumlichtbogenprozess gebildeten Plasmas verwendet. Aus Druckschrift EP 1 727 406 A1 ist ein Plasmagenerator bekannt, bei dem ein Kathodenlichtbogenplasma ausgebildet wird. Eine Hohlkathoden-Bogenentladung wird bei dem Verfahren und der Vorrichung nach EP 2 164 309 A1 erzeugt.

Der vorliegenden Erfindung liegt daher die Aufgabe zugrunde, eine Anordnung vorzuschlagen, mit der eine Plasmaverteilung gezielt beeinflussbar ist, um somit eine höhere Homogenität auch bei erhöhten Abscheideraten zu erhalten.

Diese Aufgabe wird erfindungsgemäß gelöst durch eine Vorrichtung zum Beeinflussen einer Ausbreitung eines bei einem Vakuumlichtbogenprozess gebildeten Plasmas nach Anspruch 1. Vorteilhafte Ausgestaltungen und Weiterbildungen sind in den abhängigen Ansprüchen beschrieben.

Eine Vorrichtung zum Beeinflussen einer Ausbreitung eines bei einem Vakuumlichtbogenprozess gebildeten Plasmas weist eine Vakuumkammer mit mindestens einer in der Vakuumkammer angeordneten Anode und mindestens einer in der Vakuumkammer angeordneten Kathode auf. Die mindestens eine Anode und die mindestens eine Kathode sind in einem Abstand zueinander angeordnet und an eine elektrische Stromquelle angeschlossen. In der Vakuumkammer ist ein die Anode bildendes Element angeordnet, das mindestens zwei parallel zu der Kathode ausgerichtete Schienen oder ein hohlzylinderförmiges Element aufweist. Das die Anode bildende Element ist zumindest teilweise aus einem ferromagnetischen Werkstoff ausgebildet oder zumindest teilweise mit dem ferromagnetischen Werkstoff beschichtet oder damit belegt. Alternativ kann das die Anode bildende Element aus mehreren, räumlich voneinander beabstandeten, also räumlich getrennten Teilen gebildet sein, die jeweils aus dem ferromagnetischen Werkstoff ausgebildet sind oder mit dem ferromagnetischen Werkstoff beschichtet oder belegt sind.

Durch die Kathode und die Anode wird im Vakuum ein Lichtbogen erzeugt, wobei das die Anode bildende Element verschiedene, einer Anwendung angepasste Formen aufweist. So kann auch das die Anode bildende Element konisch zulaufend mit einem hohlen Innenraum ausgebildet sein. Durch die Verwendung des ferromagnetischen Werkstoffs lässt sich über ein durch diesen ferromagnetischen Werkstoff verändertes magnetisches Feld eine Verteilung des Plasmas beeinflussen. Hierfür wird ausschließlich das durch den elektrischen Strom des Vakuumlichtbogens selbst generierte magnetische Feld genutzt. Da dieses Magnetfeld für eine hinreichend gute Eigenfokussierung des Bogenplasmas aber zunächst zu schwach ist, wird ferromagnetischer Werkstoff an dem die Anode bildenden Element angeordnet. Hierdurch ist es möglich, bestimmte Komponenten des magnetischen Felds durch einen sich ausbildenden und durch den ferromagnetischen Werkstoff geführten magnetischen Fluss zu verstärken und umgekehrt andere Komponenten abzuschwächen. So kann durch einen magnetischen Kurzschluss die Komponente des Magnetfelds, die dem magnetischen Kurzschluss am nächsten liegt, stärker reduziert werden als andere Komponenten. Durch Einstellung eines magnetischen Widerstands kann somit die Plasmaverteilung über einer Beschichtungshöhe über einen großen Bereich gesteuert werden. Unter einer Belegung eines Elements mit dem ferromagnetischen Werkstoff soll im Rahmen dieser Schrift sowohl verstanden werden, dass der ferromagnetische Werkstoff unmittelbar auf dem Element aufliegt, als auch durch Abstandhalter nur indirekt in mechanischer Verbindung zu dem Element steht, also nur mittelbar auf diesem befestigt sein kann.

Es ist somit möglich, eine Homogenisierung der Schichtdickenverteilung ohne den Einsatz von Permanentmagneten innerhalb oder außerhalb einer Beschichtungsanlage zu erreichen. Zudem ist es möglich, eine starke Fokussierung des Plasmas zu bewirken, so dass auf einer reduzierten Beschichtungshöhe mit gesteigerter Abscheiderate gearbeitet werden kann. Die so erreichte Schichtdickenverteilung ist im Gegensatz zu aus dem Stand der Technik bekannten Verfahren und Vorrichtungen unabhängig von einem Targetdurchmesser. Zudem können Inhomogenitäten, beispielsweise aufgrund von Toleranzen elektronischer Bauteile, mit der Vorrichtung kompensiert werden.

Die Schiene kann aus einem nicht-ferromagnetischen Werkstoff ausgebildet sein, vorzugsweise einem paramagnetischen oder sogar rein diamagnetischen Werkstoff. Hierdurch wird eine Beeinflussung des von dem Lichtbogen erzeugten Magnetfelds nur durch den ferromagnetischen Werkstoff möglich. Auf einer dem Plasma zugewandten oder auf einer dem Plasma abgewandten Seite kann dann die Schiene mit dem ferromagnetischen Werkstoff beschichtet oder belegt sein, so dass durch eine Einstellung des Abstands auch eine Einstellung einer Stärke einer Beeinflussung des Plasmas erfolgen kann. Ebenso kann auch, falls das hohlzylinderförmige Element verwendet wird, dieses aus dem nicht-ferromagnetischen Werkstoff ausgebildet und wie beschrieben mit dem ferromagnetischen Werkstoff beschichtet oder belegt sein.

Es ist hierzu an der Schiene mindestens ein streifenförmiges Element aus dem ferromagnetischen Werkstoff vorhanden, worunter eine vakuumtaugliche Befestigung des streifenförmigen Elements auf der Schiene verstanden werden soll, beispielsweise durch Schrauben oder Punktschweißen. Die Befestigung kann hierbei sowohl direkt, also in unmittelbarem berührendem Kontakt, als auch indirekt, also nur in mittelbar berührendem Kontakt, beispielsweise durch einen Abstandshalter, erfolgen. Durch die Verwendung eines streifenförmigen Elements, also eines Elements, bei dem eine Länge größer als eine Breite und eine Dicke ist, kann ein magnetischer Kurzschluss entlang einer Längsachse des streifenförmigen Elements einfach eingestellt und der magnetische Widerstand entsprechend verringert werden. Vorzugsweise ist an jeder der Schienen ein entsprechendes streifenförmiges Element angebracht. Das streifenförmige Element kann sowohl einen in Längsrichtung betrachteten rechteckigen Querschnitt als auch einen runden oder beliebig geformten Querschnitt aufweisen.

Das die Anode bildende Element weist mindestens zwei parallel zu der Kathode und vorzugsweise parallel zueinander ausgerichtete Schienen auf, um eine symmetrische Plasmaausbildung zu unterstützten. Diese mindestens zwei Schienen können die zuvor beschriebenen Eigenschaften aufweisen.

Bei Verwenden von zwei Schienen kann sowohl nur an einer der beiden Schienen das mindestens eine streifenförmige Element angeordnet sein, es können aber auch beide Schienen mit jeweils mindestens einem streifenförmigen Element versehen sein.

Mindestens eines der streifenförmigen Elemente ist an einer Stirnseite einer der Schienen in Richtung der jeweils anderen Schiene gebogen oder abgewinkelt. Durch das Biegen kann der magnetisehe Fluss geführt werden. Sofern nur eine einzelne Schiene verwendet wird, kann das streifenförmige Element an einem Ende dieser Schiene in beliebige Richtungen gebogen oder abgewinkelt sein.

Vorzugsweise überlappen sich die streifenförmigen Elemente im stirnseitigen Bereich, so dass der magnetische Fluss zumindest an dieser Stelle definiert geführt ist. Die einander räumlich überlappenden streifenförmigen Elemente sind typischerweise räumlich voneinander getrennt, also voneinander beabstandet und weisen keinen direkten berührenden Kontakt miteinander auf.

Alternativ oder zusätzlich kann das die Anode bildende Element aus mehreren Lagen ausgebildet sein, wobei mindestens eine der Lagen aus dem ferromagnetischen Werkstoff gebildet ist. Dies erlaubt es, einen Abstand zwischen dem Plasma und dem ferromagnetischen Element gezielt einzustellen.

Der ferromagnetische Werkstoff ist typischerweise ausgewählt aus ferromagnetischem Baustahl, ferromagnetischem Edelstahl, Eisen, Nickel, Kobalt, einer Legierung derselben oder einer ferromagnetischen Keramik.

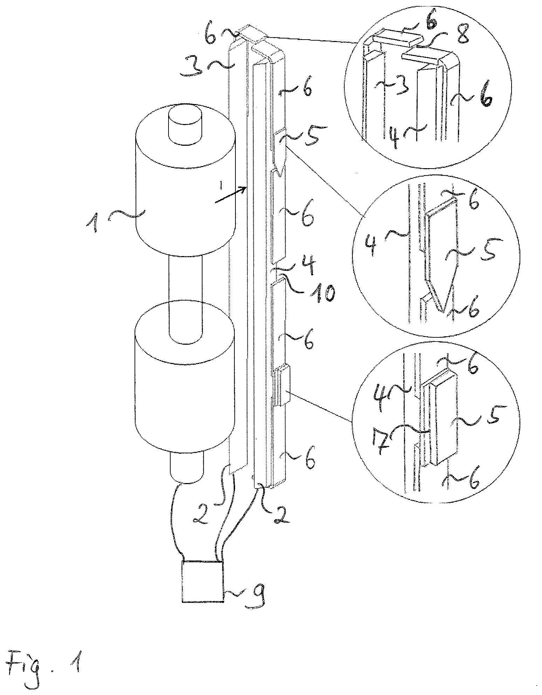

Ein Ausführungsbeispiel der Erfindung ist in der Zeichnung gezeigt und wird anhand Figur 1 erläutert.

Figur 1 zeigt in einer perspektivischen Ansicht eine Kathode 1 und eine Anode 2, die in einer Vakuumkammer angeordnet sind. Die Kathode 1 und die Anode 2 sind mit einer schematisch dargestellten elektrischen Stromquelle 9 verbunden. Durch die Kathode 1 und die Anode 2 wird bei einem Laser-Arc-Prozess ein Lichtbogen ausgebildet. Hierzu ist die Kathode 1 als zylindrisches Target ausgebildet sowie unmittelbar vor zwei aus einem nichtferromagnetischen Stahl gefertigten Anodenschienen 3 und 4 angeordnet. Die Anodenschienen 3 und 4 sind parallel zu der Kathode 1 und parallel zueinander ausgerichtet, in weiteren Ausführungsbeispielen kann statt der Anodenschienen 3 und 4 als das die Anode 2 bildende Element aber auch ein hohlzylinderförmiges Element oder ein konisch zulaufendes Element bzw. eine Rundanode verwendet werden. Alternativ kann auch nur eine der Schienen 3 und 4 in der Vakuumkammer angeordnet sein.

Ein während einer Ausbildung eines Lichtbogens von einer Kathodenoberfläche in Richtung der Anode 2 emittiertes Plasma, typischerweise ein Kohlenstoffplasma, trägt einen elektrischen Bogenstrom, der eine elektrische Stromstärke von beispielsweise mehr als 800 A aufweist. Dieser Bogenstrom bildet ein kreisförmiges magnetisches Feld um sich aus. Auf den Schienen 3 und 4 sind ferromagnetische Bleche 6 aus Baustahl angeordnet und durch Schrauben befestigt. Im dargestellten Ausführungsbeispiel sind die ferromagnetischen Bleche 6 streifenförmig und ihre Längsachse liegt vertikal. Somit werden vertikale Komponenten des sich ausbildenden Magnetfelds kurzgeschlossen, horizontale Komponenten des Magnetfelds oberhalb und unterhalb des Bogens jedoch verstärkt. Entsprechend der Lorentz-Kraft kommt es damit zu einer vertikalen Ablenkung des Plasmas. In weiteren Ausführungsbeispielen können auch die Schienen 3 und 4 selbst teilweise oder gänzlich aus einem ferromagnetischen Werkstoff sein.

Oberhalb des Lichtbogens hat das horizontale magnetische Feld eine Richtung, die das Plasma im dargestellten Ausführungsbeispiel nach unten lenkt. Unterhalb des Lichtbogens hat das magnetische Feld hingegen die entgegengesetzte Richtung und das Plasma wird nach oben abgelenkt. Brennt der Lichtbogen an einem aufgrund eines Spalts 10 zwischen den ferromagnetischen Blechen 6 offenen Ende, wird das Plasma, wenn es oberhalb des offenen Endes brennt, nach oben abgelenkt, und wenn es unterhalb des offenen Endes brennt, nach unten abgelenkt.

Bei einem symmetrischen Aufbau der Anode 2 und der aufgesetzten ferromagnetischen Bleche 6 wird das Plasma bei dem in Figur 1 dargestellten Ausführungsbeispiel auf halber Höhe nicht abgelenkt. Brennt der Bogen in der Nähe des offenen Endes der Anode 2, wird das horizontale magnetische Feld, das dem offenen Ende der Anode 2 näher liegt, infolge des parallel liegenden höheren magnetischen Widerstands stärker. Das Plasma wird daher am unteren offenen Ende der Anode 2 nach oben abgelenkt und die den beiden Kathodenwalzen der Kathode 1 zugeordneten Maxima des Plasmas zur Mitte abgelenkt.

Um die Stärke der Umlenkung einzustellen, kann der magnetische Widerstand eingestellt werden. Hierzu kann, wie in Figur 1 rechts oben vergrößert dargestellt, zumindest eines oder es können auch beide der ferromagnetischen Bleche 6 an einer Stirnseite der Anodenschienen 3 und 4 in Richtung der jeweils anderen Schiene gebogen sein. Die gebogenen ferromagnetischen Bleche 6 sind in dem stirnseitigen Bereich zwar einander überlappend, aber voneinander durch einen Spalt 8 beabstandet ausgeführt. Durch eine Größe des Spalts 8 kann der magnetische Widerstand an dieser Position eingestellt werden.

Ebenso kann zum Einstellen der Stärke der Umlenkung, wie in Figur 1 rechts mittig vergrößert dargestellt, ein an einem Ende sich verjüngend zulaufend geformtes ferromagnetisches Blech 5 benutzt werden, das mit zwei der ferromagnetischen Bleche 6 in berührendem Kontakt steht, wodurch eine überlappende Fläche zu den streifenförmigen ferromagnetischen Blechen 6 gegeben ist und damit der magnetische Widerstand justiert werden kann.

Schließlich kann auch, wie in Figur 1 rechts unten vergrößert gezeigt, ein mit Abstand aufgebrachtes Blech 5 verwendet werden. Als Abstandshalter 7 wird in dem dargestellten Ausführungsbeispiel ein nicht-ferromagnetisches Blech aus V2A oder einem anderen nicht-ferromagnetischen Werkstoff verwendet. Eine Breite oder eine Länge des aufgebrachten ferromagnetischen Blechs 5 können hierbei kleiner als eine Breite bzw. eine Länge des Abstandshalters 7 sein. Der Abstandshalter 7 ist hierbei mit zwei der ferromagnetischen Bleche 6 in berührendem Kontakt und das ferromagnetische Blech 5 ist in dem dargestellten Ausführungsbeispiel direkt auf den Abstandshalter 7 aufgebracht.

Durch Auftrennen der magnetischen Kurzschlüsse und der als Seitenbleche dienenden ferromagnetischen Bleche 6 an geeigneten Stellen und Justage ihres magnetischen Widerstands durch geeignet aufgesetzte ferromagnetische Elemente 5 kann daher die Plasmaverteilung eingestellt werden, so dass eine Homogenisierung der Schichtdickenverteilung ohne einen Einsatz von Permanentmagneten innerhalb oder außerhalb einer Beschichtungsanlage möglich ist. Bei Anordnungen mit Permanentmagneten müssen diese innerhalb der Vakuumkammer gekapselt und aufwändig wassergekühlt werden. Bei Anordnungen mit Permanentmagneten außerhalb der Vakuumkammer muss der magnetische Fluss über sperrige magnetische Brücken von den Kammerwänden zur Spannung führenden Anode weitergeleitet werden. Bei der beschriebenen Vorrichtung kann auf die wegen einer Temperaturempfindlichkeit der Permanentmagnete aufwändige Kapselung und Kühlung verzichtet werden und eine Änderung der magnetischen Feldstärke aufgrund eines im Anodenbereich häufigen Reinigungszyklus, d. h. Ausbau und Sandstrahlen aller Komponenten, ist aufgrund eines Fehlens magnetischer Brücken und deren Dejustage ausgeschlossen.

## Patentansprüche

1. Vorrichtung zum Beeinflussen einer Ausbreitung eines bei einem Vakuumlichtbogenprozess gebildeten Plasmas,
mit einer Vakuumkammer,
in der mindestens eine Anode (2) und mindestens eine Kathode (1) in einem Abstand zueinander angeordnet und an eine elektrische Stromquelle (9) angeschlossen sind, wobei
in der Vakuumkammer ein die Anode bildendes Element (2) angeordnet ist, das
mindestens zwei parallel zu der Kathode (1) ausgerichtete Schienen (3, 4) aufweist, wobei
das die Anode bildende Element (2) zumindest teilweise aus einem ferromagnetischen Werkstoff ausgebildet ist
oder
zumindest teilweise mit dem ferromagnetischen Werkstoff beschichtet oder damit belegt ist
oder
aus mehreren, räumlich voneinander beabstandeten Teilen gebildet ist, die jeweils aus dem ferromagnetischen Werkstoff ausgebildet sind oder mit dem ferromagnetischen Werkstoff beschichtet oder belegt sind, **dadurch gekennzeichnet, dass**
an den Schienen (3, 4) mindestens ein streifenförmiges Element (5, 6) aus dem ferromagnetischen Werkstoff vorhanden ist, wobei
mindestens eines der streifenförmigen Elemente (5, 6) an einer Stirnseite einer der Schienen (3, 4) in Richtung der jeweils anderen Schiene (3, 4) gebogen oder abgewinkelt ist.

2. Vorrichtung nach Anspruch 1, **dadurch gekennzeichnet, dass** die Schiene (3, 4) aus einem nicht-ferromagnetischen Werkstoff ausgebildet ist und auf einer dem Plasma zugewandten Seite oder einer dem Plasma abgewandten Seite mit dem ferromagnetischen Werkstoff beschichtet oder belegt ist.

3. Vorrichtung nach Anspruch 1 oder Anspruch 2, **dadurch gekennzeichnet, dass** das die Anode bildende Element (2) mindestens zwei parallel zueinander ausgerichtete Schienen (3, 4) aufweist.

4. Vorrichtung nach Anspruch 1, **dadurch gekennzeichnet, dass** sich streifenförmige Elemente (5, 6) im stirnseitigen Bereich überlappen.

5. Vorrichtung nach Anspruch 4, **dadurch gekennzeichnet, dass** die einander überlappenden streifenförmigen Elemente (5, 6) räumlich voneinander getrennt sind.

6. Vorrichtung nach einem der vorhergehenden Ansprüche, **dadurch gekennzeichnet, dass** das die Anode bildende Element (2) aus mehreren Lagen (4, 5, 6, 7) ausgebildet ist, wobei mindestens eine der Lagen (4, 5, 6, 7) aus dem ferromagnetischen Werkstoff gebildet ist.

7. Vorrichtung nach einem der vorhergehenden Ansprüche, **dadurch gekennzeichnet, dass** der ferromagnetische Werkstoff ausgewählt ist aus ferromagnetischem Baustahl, ferromagnetischem Edelstahl, Eisen, Nickel, Kobalt, einer Legierung derselben oder einer ferromagnetischen Keramik.

## Claims

1. Device for influencing a propagation of a plasma formed during a vacuum arc process,
with a vacuum chamber,
in which at least one anode (2) and at least one cathode (1) are arranged at a distance from one another and are connected to an electrical power source (9), wherein
arranged in the vacuum chamber is an element (2) forming the anode, which
has at least two rails (3, 4) aligned parallel to the cathode (1), wherein
the element (2) forming the anode is at least partially formed from a ferromagnetic material
or
is at least partially coated with the ferromagnetic material or covered therewith
or
is formed by a number of parts that are spatially at a distance from one another and are respectively formed from the ferromagnetic material or are coated or covered with the ferromagnetic material, **characterized in that**
on the rails (3, 4) there is at least one strip-shaped element (5, 6) of the ferromagnetic material, wherein
at least one of the strip-shaped elements (5, 6) is curved or angled away at an end face of one of the rails (3, 4) in the direction of the respective other rail (3, 4).

2. Device according to Claim 1, **characterized in that** the rail (3, 4) is formed from a non-ferromagnetic material and is coated or covered with the ferromagnetic material on a side facing the plasma or a side facing away from the plasma.

3. Device according to Claim 1 or Claim 2, **characterized in that** the element (2) forming the anode has at least two rails (3, 4) aligned parallel to one another.

4. Device according to Claim 1, **characterized in that** strip-shaped elements (5, 6) overlap in the end region.

5. Device according to Claim 4, **characterized in that** the overlapping strip-shaped elements (5, 6) are spatially separate from one another.

6. Device according to one of the preceding claims, **characterized in that** the element (2) forming the anode is formed by multiple layers (4, 5, 6, 7), wherein at least one of the layers (4, 5, 6, 7) is formed from the ferromagnetic material.

7. Device according to one of the preceding claims, **characterized in that** the ferromagnetic material is selected from ferromagnetic structural steel, ferromagnetic stainless steel, iron, nickel, cobalt, an alloy of the same or a ferromagnetic ceramic.

## Revendications

1. Dispositif destiné à influencer une propagation d'un plasma formé selon un procédé d'arc électrique sous vide,
avec une chambre à vide,
dans laquelle au moins une anode (2) et au moins une cathode (1) sont disposées à distance l'une de l'autre et sont connectées à une source de courant électrique (9), dans lequel,
dans la chambre à vide, il est disposé un élément (2) formant l'anode
qui comporte au moins deux rails (3, 4) orientés parallèlement à la cathode (1), dans lequel
l'élément (2) formant l'anode est constitué au moins partiellement en matériau ferromagnétique
ou
est revêtu au moins partiellement avec le matériau ferromagnétique ou en est recouvert
ou
est formé de plusieurs parties distantes les unes des autres dans l'espace qui sont constituées respectivement du matériau ferromagnétique ou sont revêtues ou recouvertes de matériau ferromagnétique, **caractérisé en ce**
**qu'**au moins un élément (5, 6) en forme de bande en matériau ferromagnétique est présent sur les rails (3, 4), dans lequel,
sur un côté frontal d'un des rails (3, 4), au moins un des éléments (5, 6) en forme de bande est courbé ou coudé en direction de respectivement l'autre rail (3, 4).

2. Dispositif selon la revendication 1, **caractérisé en ce que** le rail (3, 4) est constitué d'un matériau non ferromagnétique et, sur un côté tourné vers le plasma ou sur un côté opposé au plasma, est revêtu ou recouvert du matériau ferromagnétique.

3. Dispositif selon la revendication 1 ou la revendication 2, **caractérisé en ce que** l'élément (2) formant l'anode comporte au moins deux rails (3, 4) orientés parallèlement l'un à l'autre.

4. Dispositif selon la revendication 1, **caractérisé en ce que** des éléments (5, 6) en forme de bande se chevauchent dans la zone côté frontal.

5. Dispositif selon la revendication 4, **caractérisé en ce que** les éléments (5, 6) en forme de bande qui se chevauchent sont séparés les uns des autres dans l'espace.

6. Dispositif selon l'une des revendications précédentes, **caractérisé en ce que** l'élément (2) formant l'anode est constitué de plusieurs couches (4, 5, 6, 7), dans lequel au moins une des couches (4, 5, 6, 7) est formée du matériau ferromagnétique.

7. Dispositif selon l'une des revendications précédentes, **caractérisé en ce que** le matériau ferromagnétique est sélectionné parmi l'acier de construction ferromagnétique, l'acier spécial ferromagnétique, le fer, le nickel, le cobalt, un alliage de ceux-ci ou une céramique ferromagnétique.
